# EUROPEAN PATENT SPECIFICATION

(11) **EP 3 993 582 B1**
(45) Date of publication and mention of the grant of the patent: **26.06.2024**
(21) Application number: 20205229.6
(22) Date of filing: 02.11.2020
(51) Int. Cl.: H05K 7/14

(54) **SHELF FOR MOUNTING OF AN ELECTRICAL DEVICE WITHIN A RACK AND RACK WITH AT LEAST ONE SHELF OF THIS TYPE**
REGAL ZUR MONTAGE EINER ELEKTRISCHEN VORRICHTUNG IN EINEM GESTELL UND GESTELL MIT MINDESTENS EINEM SOLCHEN REGAL
ÉTAGÈRE POUR LE MONTAGE D'UN DISPOSITIF ÉLECTRIQUE DANS UN BÂTI ET BÂTI COMPRENANT AU MOINS UNE ÉTAGÈRE DE CE TYPE

(43) Date of publication of application: 04.05.2022
(73) Proprietor: Rohde & Schwarz GmbH & Co. KG, 81671 München (DE)
(72) Inventor: Gualtieri, Francesco, 81671 München (DE)
(74) Representative: Novagraaf Group

(56) References cited:
- WO-A2-2010/138824
- KR-B1- 102 134 338
- US-A- 4 555 744
- US-A1- 2010 315 788

## Description

The invention relates to the mounting of professional radios in racks, in particular of radios which are used for air traffic control.

For quite some time, radios had housings adapted to be mounted in 19 inch racks. In recent year, more compact radios have been widely employed, these radios often having a width which is half of the standard size. Accordingly, two radios are mechanically connected to each other, usually by means of a dedicated sheet metal plate, and then mounted as a unit at the place where previously a single radio had been installed.

Should there be a need to repair or replace one of the radios, it is necessary to remove the entire unit from the rack and disassemble the unit formed from the two radios. Should it not be possible to reinstall one of the two radios, for example because of a more significant repair being necessary which requires sending the radio to the manufacturer, the other radio cannot be readily installed in the rack as the width of the single radio is not sufficient for mounting the radio in a stable manner between the vertically extending posts of the rack.

The US 4 555 744 A discloses an electrically grounded storage cabinet for electrical circuit board modules with multiple rectangular arrays of brackets for receiving at least one pair of conductive rectangular shelves. The shelves are slidably adjustable in elevation relative to each other on the brackets.

The US 2010/315788 A1 discloses a cooling system for rack-mounted equipment comprising a box-shaped shelf. The shelf comprises a top panel, an opposing bottom panel, a first side panel, an opposing second side panel, a front panel and a rear panel having at least one vent.

The KR 102 134 338 B1 discloses a rack shelf for mounting electrical half-type devices. The shelf comprises a base plate with an anti-slip bracket and at least one magnetic member for holding the half-type device by magnetic force.

The object of the invention is to provide means for mounting radios in a rack so as to allow a more simple mounting and removal of the radios.

In order to achieve this object, the invention provides a shelf for mounting of an electrical device within a rack, comprising a bottom portion, a left and a right attachment portion connected to the bottom portion and adapted for mounting the shelf on vertical posts of the rack, further comprising a right and a left guide portion on opposite sides of the bottom portion, the bottom portion having at a rear side two ground lugs that are configured so as to form a rear stop which prevents the electrical device from being excessively pushed into the shelf wherein each ground lug is provided with a ground screw that is captively held in the ground lug and wherein each ground screw is configured so that a ground connection is established between the electrical device and the shelf when the electrical device is placed in its position on the shelf and when the ground screw is tightened. The above object is also achieved with a rack having a plurality of vertical posts and at least one shelf of this type.

The invention is based on the concept of providing in the rack a separate element, namely the shelf, which is used for receiving and mounting the radios. The shelf acts in a manner similar to a tray and allows mounting the radios separately, without there being a need to connect two radios to each other so as to form a unit. Should one of the radios mounted in the shelf require maintenance or repair, it can be removed from the rack separately, without there being any need to manipulate the second radio. For mounting, each radio can be placed on the bottom portion of the shelf, with the respective guide portion ensuring that the radio can be easily placed in the correct position. Further, the guide portions add to the mechanical stability of the shelf. The ground screw allows to easily establish a ground connection for the respective radio. It is captively held in the ground lug so that there is no risk of the ground screw becoming detached.

According to an embodiment, the guide portions have at least one mounting lug adapted for connecting the shelf to the rack, the mounting lug being arranged at a distance from the attachment portions. The mounting lugs allow connecting the shelf to an additional or intermediate vertical mounting struts of the rack, thereby increasing the stability with which the shelf is held within the rack.

The shelf may be provided with two connecting struts each connecting with a screw connection to one of the guide parts, the connecting struts being adapted for being attached to a vertical post of the rack. The connecting struts allow adapting the shelf to different dimensions of the rack so that an increased flexibility is achieved.

Preferably, a guiding structure is provided centrally between the guide portions so as to ensure that a radio is probably guided into its position in which the ground screw can be tightened, even if no second radio is present in the shelf. One of the guide portions in combination with the guiding structure defines kind of a receiving slot for the radio.

The guiding structure can be formed by protrusions provided on the bottom portion of the shelf, the protrusions preferably being plastically deformed parts of the bottom portion. This type of guiding structure can be provided during manufacture of the shelf with little extra expense.

Preferably, the ground screw has a head adapted for being tightened by hand so no dedicated tool is necessary for mounting the radio in the shelf.

According to an embodiment, the attachment portions, the guide portions and the ground lug are formed in one piece from sheet metal. This unitary construction of the shelf at the one hand ensures a reliable ground connection from the ground lug to the attachment portions. On the other hand, it is possible to form the entire shelf as a stemmed and bent sheet metal part at low costs.

The invention will now be described with reference to the enclosed drawings. In the drawings,
1. Figure 1 shows in a perspective view part of a rack equipped with two shelves according to the invention, each shelf carrying two radios,
2. Figure 2 shows in a perspective front view one of the shelves used in Figure 1,
3. Figure 3 shows the unit of Figure 2 in a perspective rear view,
4. Figure 4 shows in a perspective front view a different embodiment of a shelf equipped with two radios,
5. Figure 5 shows in a perspective rear view a shelf according to a second embodiment, and
6. Figure 6 shows in perspective rear view an alternative to the second embodiment.

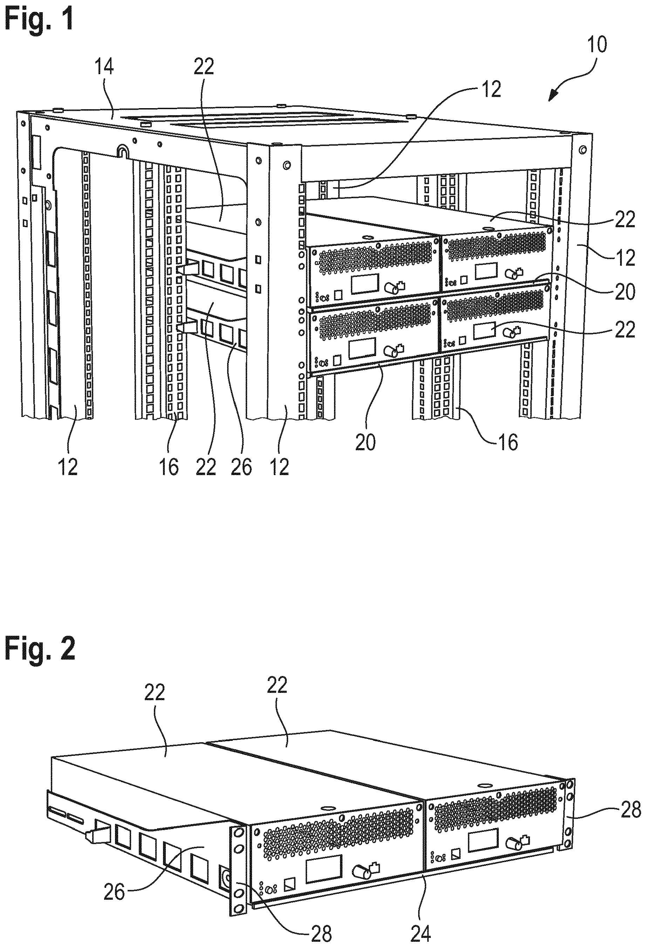

In Figure 1, the upper portion of a rack 10 is shown, which has four vertically extending posts 12 connected to a top cover 14. A floor element is not visible in Figure 1.

At two opposite sides, intermediate mounting struts 16 are provided which also extend vertically.

Within rack 10, two shelves 20 are mounted, which each carry two radios 22.

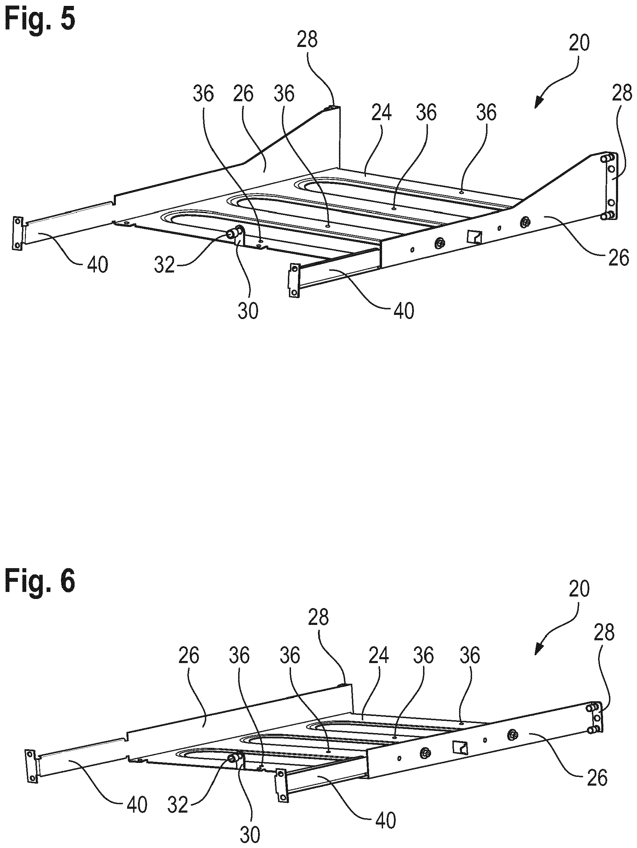

Each shelf 20 consists (please see also Figure 5 where an embodiment of the shelf is shown without radio) of a bottom portion 24, which is provided at opposite sides with a right and left guide portion 26. Each of the guide portions 26 is provided with an attachment portion 28.

Bottom portion 24 together with the two vertically rising guide portions 26 has the shape of a tray, and the two attachment portions extend at an angle of 90° from the guide portions on their side facing away from the bottom portion 24. In the space between the guiding portions 26, two radios 22 can be received.

At its rear end, bottom portion 24 is provided with two ground lugs 30 which extend at an angle of 90° upwardly from bottom portion 24. Each ground lug 30 is provided with a ground screw 32.

Ground screw 32 is captively held in ground lug 30 so that there is no risk of ground screw 32 becoming detached from the shelf. Furthermore, ground screw 32 has a head which is adapted for being tightened by hand so that it is not necessary to use a dedicated tool in the interior of the rack at a side which is not easily accessible.

In the embodiment of Figures 1 to 3, each shelf has a mounting lug 34 which is provided in the respective guide portion at a distance from the attachment portions. Attachment lugs 34 serve for connecting shelf 20 to the intermediate mounting struts 16 in the configuration of rack 10 as shown in Figure 1.

For mounting the shelves in the rack, the mounting lugs are inserted into an appropriate opening in the intermediate mounting struts 16, and the attachment portions 28 are connected to the forward vertical posts 12 of rack 10, for example by means of screws.

The shelves can then be equipped with one radio 22 or with two radios 22, which can simply be placed on the right or the left side of shelf 20. Ground lug 30 forms a rear stop which prevents the radios 22 from being excessively pushed into the shelf. Guide portions 26 form a right and a left guide, and a guiding structure 36 forms a central guide.

Guiding structure 36 is formed by a plurality of small protrusions which are formed by plastically deforming bottom portion 24.

After placing the radio 22 in its position on shelf 20, ground screw 32 is tightened so that there is a ground connection via shelf 20 to rack 10.

The entire shelf 20 with bottom portion 24, the lateral guide portions 26, the attachment portions 28 and ground lug 30 is preferably formed in one piece from stemmed and bent sheet metal.

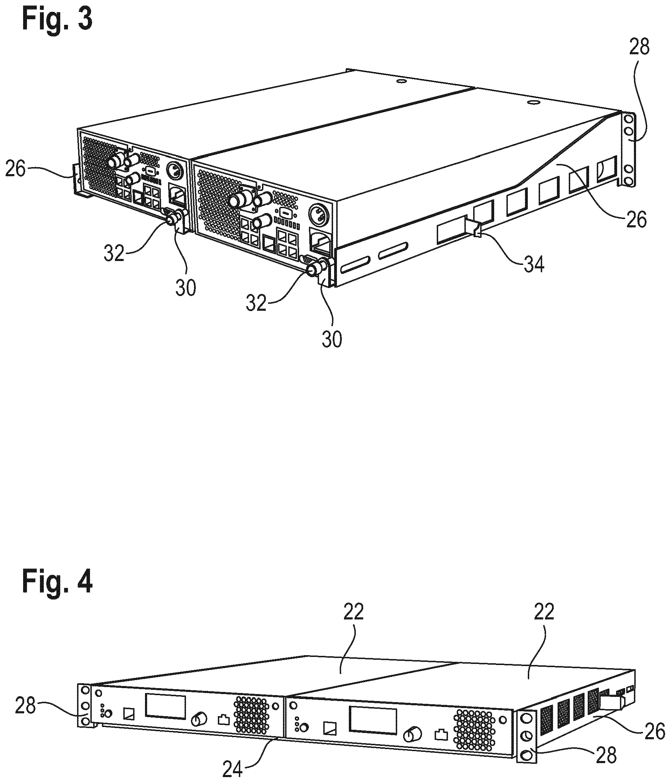

The alternative shown in Figure 4 differs from the embodiment shown in Figures 1, 2 and 3 in that it has a reduced height, adapted for receiving radios 22 having a height which is smaller than the height of the radios 22 received in the shelves 20 shown in Figure 1 to 3.

In Figure 5, an embodiment is shown which differs from the embodiment shown in Figures 1 to 3 in that two connecting struts 40 are screwed to guide portions 26, each connecting strut 40 extending beyond the rear side of bottom portion 24 at its side opposite attachment portions 28. Connecting struts 40 are adapted for being connected to the rear vertical posts 12 of rack 10. This results in increased stability.

In Figure 6, an alternative is shown which largely corresponds to the embodiment shown in Figure 5. In a manner similar to the difference between the embodiments of Figures 4 and 3, Figure 6 shows an alternative adapted for receiving radios with a reduced height.

## Claims

1. Shelf (20) for mounting of an electrical device (22) within a rack (10), comprising a bottom portion (24), a left and a right attachment portion (28) connected to the bottom portion (24) and adapted for mounting the shelf (20) on vertical posts (12) of the rack, further comprising a right and a left guide portion (26) on opposite sides of the bottom portion (24), **characterized in that** the bottom portion (24) has at a rear side two ground lugs (30) that are configured so as to form a rear stop which prevents the electrical device from being excessively pushed into the shelf (20) wherein each ground lug (30) is provided with a ground screw (32) that is captively held in the ground lug (30) and wherein each ground screw (32) is configured so that a ground connection is established between the electrical device (22) and the shelf (20) when the electrical device (22) is placed in its position on the shelf (20) and when the ground screw (32) is tightened.

2. The shelf (20) of claim 1 wherein the guide portions (26) have at least one mounting lug (34) adapted for connecting the shelf (20) to the rack (10), the mounting lugs (34) being arranged at a distance from the attachment portions (28).

3. The shelf (20) of claim 1 or claim 2, further having two connecting struts (40) each connected with a screw connection to one of the guide parts (26), the connecting struts (40) being adapted for being attached to a vertical post (12) of the rack (10).

4. The shelf (20) of any of the preceding claims wherein a guiding structure (36) is provided centrally between the guide portions (26).

5. The shelf (20) of claim 4 wherein the guiding structure (36) is formed by protrusions (36) provided on the bottom portion (24), the protrusions (36) preferably being plastically deformed parts of the bottom portion (24).

6. The shelf (20) of any of the preceding claim wherein the ground screw (32) has a head adapted for being tightened by hand.

7. The shelf (20) of any of the preceding claims wherein the bottom portion (24), the attachment portions (28), the guide portions (26) and the ground lugs (30) are formed in one piece from sheet metal.

8. A rack (10) with a plurality of vertical posts (12) and at least one shelf (20) as defined in any of the preceding claims.

## Patentansprüche

1. Regal (20) zum Montieren einer elektrischen Vorrichtung (22) innerhalb eines Gestells (10), umfassend einem Bodenabschnitt (24), einen linken und einen rechten Befestigungsabschnitt (28), die mit dem Bodenabschnitt (24) verbunden sind und zum Montieren des Regals (20) an vertikalen Pfosten (12) des Gestells angepasst sind, ferner umfassend einen rechten und einen linken Führungsabschnitt (26) auf gegenüberliegenden Seiten des Bodenabschnitts (24), **dadurch gekennzeichnet, dass** der Bodenabschnitt (24) an einer hinteren Seite zwei Erdungsösen (30) aufweist, die konfiguriert sind, um einen hinteren Anschlag auszubilden, der verhindert, dass die elektrische Vorrichtung übermäßig in das Regal (20) gedrückt wird, wobei jede Erdungsöse (30) mit einer Erdungsschraube (32) versehen ist, die unverlierbar in der Erdungsöse (30) gehalten wird, und wobei jede Erdungsschraube (32) konfiguriert ist, sodass eine Erdungsverbindung zwischen der elektrischen Vorrichtung (22) und dem Regal (20) hergestellt wird, wenn die elektrische Vorrichtung (22) in ihrer Position auf dem Regal (20) platziert wird und wenn die Erdungsschraube (32) angezogen wird.

2. Regal (20) nach Anspruch 1, wobei die Führungsabschnitte (26) mindestens eine Montageöse (34) aufweisen, die zum Verbinden des Regals (20) mit dem Gestell (10) angepasst ist, wobei die Montageösen (34) in einem Abstand vom den Befestigungsabschnitten (28) angeordnet sind.

3. Regal (20) nach Anspruch 1 oder 2, das ferner zwei Verbindungsstreben (40) aufweist, die jeweils mit einer Schraubverbindung mit einem der Führungsteile (26) verbunden sind, wobei die Verbindungsstreben (40) angepasst sind, um an einem vertikalen Pfosten (12) des Regals (10) befestigt zu werden.

4. Regal (20) nach einem der vorstehenden Ansprüche, wobei eine Führungsstruktur (36) mittig zwischen den Führungsabschnitten (26) bereitgestellt ist.

5. Regal (20) nach Anspruch 4, wobei die Führungsstruktur (36) durch Vorsprünge (36) ausgebildet ist, die auf dem Bodenabschnitt (24) bereitgestellt sind, wobei die Vorsprünge (36) vorzugsweise plastisch verformte Teile des Bodenabschnitts (24) sind.

6. Regal (20) nach einem der vorstehenden Ansprüche, wobei die Erdungsschraube (32) einen Kopf aufweist, der angepasst ist, um von Hand angezogen zu werden.

7. Regal (20) nach einem der vorstehenden Ansprüche, wobei der Bodenabschnitt (24), die Befestigungsabschnitte (28), die Führungsabschnitte (26) und die Erdungsösen (30) in einem Stück aus Metallblech ausgebildet sind.

8. Gestell (10) mit einer Vielzahl von vertikalen Pfosten (12) und mindestens einem Regal (20) nach einem der vorstehenden Ansprüche.

## Revendications

1. Support (20) destiné à l'installation d'un appareil électrique (22) dans une étagère (10), comprenant une partie inférieure (24), une partie de fixation gauche et une partie de fixation droite (28) reliées à la partie inférieure (24) et adaptées au montage du support (20) sur les montants verticaux (12) de l'étagère, comprenant en outre une partie de guidage droite et une partie de guidage gauche (26) sur les côtés opposés de la partie inférieure (24), **caractérisé en ce que** la partie inférieure (24) a, à l'arrière, deux pattes de mise à la terre (30) configurées de manière à former une butée arrière qui empêche l'appareil électrique d'être excessivement enfoncé dans le support (20), dans lequel chaque patte de mise à la terre (30) est pourvue d'une vis de mise à la terre (32) maintenue de manière captive dans la patte de mise à la terre (30) et dans lequel chaque vis de mise à la terre (32) est conçue de manière à établir une connexion à la terre entre le dispositif électrique (22) et le support (20) lorsque le dispositif électrique (22) est placé dans sa position sur le support (20) et lorsque la vis de mise à la terre (32) est serrée.

2. Support (20) selon la revendication 1, dans lequel les parties de guidage (26) ont au moins une patte de montage (34) adaptée pour relier le support (20) à l'étagère (10), les pattes de montage (34) étant disposées à une certaine distance des parties de fixation (28).

3. Support (20) selon la revendication 1 ou la revendication 2, ayant en outre deux entretoises de liaison (40) reliées chacune par une vis à l'une des parties de guidage (26), les entretoises de liaison (40) étant adaptées pour être fixées à un montant vertical (12) de l'étagère (10).

4. Support (20) selon l'une quelconque des revendications précédentes, dans lequel une structure de guidage (36) est prévue au centre entre les parties de guidage (26).

5. Support (20) selon la revendication 4, dans lequel la structure de guidage (36) est formée par des saillies (36) prévues sur la partie inférieure (24), les saillies (36) étant de préférence des parties plastiquement déformées de la partie inférieure (24).

6. Support (20) selon l'une quelconque des revendications précédentes, dans lequel la vis de mise à la terre (32) a une tête adaptée pour être serrée à la main.

7. Support (20) selon l'une quelconque des revendications précédentes, dans lequel la partie inférieure (24), les parties de fixation (28), les parties de guidage (26) et les pattes de mise à la terre (30) sont formées d'une seule pièce en tôle.

8. Étagère (10) avec plusieurs montants verticaux (12) et au moins un support (20) selon l'une quelconque des revendications précédentes.
